# EUROPÄISCHE PATENTSCHRIFT

(11) **EP 0 573 685 B1**
(45) Veröffentlichungstag und Bekanntmachung des Hinweises auf die Patenterteilung: **02.05.1997**
(21) Anmeldenummer: 92109689.7
(22) Anmeldetag: 09.06.1992
(51) Int. Cl.: H04N 5/907, G09G 1/16, G11C 7/00

(54) **Integrierte Halbleiterspeicheranordnung**
Integrated semiconductor memory device
Circuit intégré de mémoire à semiconducteur

(43) Veröffentlichungstag der Anmeldung: 15.12.1993
(73) Patentinhaber: SIEMENS AKTIENGESELLSCHAFT, 80333 München (DE)
(72) Erfinder: Lüder, Rainer, Dr. Dr.-Ing., W-8024 Oberhaching (DE); Meyer, Willibald, Dipl.-Ing., W-8000 München 83 (DE); Braun, Bodo, Dr. Dr.-Ing., W-8011 Siegertsbrunn (DE)

(56) Entgegenhaltungen:
- EP-A- 0 246 767
- EP-A- 0 340 841
- EP-A- 0 386 841

## Beschreibung

Die Erfindung betrifft eine integrierte Halbleiterspeicheranordnung zum Abspeichern der Bildpunktdaten eines Fernsehbildes.

Unter den integrierten Schaltungen in HDTV-Empfängern nehmen Bildspeicher eine zentrale Rolle ein; ein Großteil der Signalverarbeitungsfunktion wirkt räumlich-zeitlich, wofür eine Zwischenspeicherung eines oder mehrerer Halbbilder notwendig ist. Insbesondere werden - je nach Ausführungsform - im Bandwidth Restauration Decoder drei bis fünf Halbbildspeicher verwendet. Zur Display-Konversion von normal aufgelösten Videosignalen (einschließlich D2-MAC und PALplus) sind ebenfalls ein bis drei Halbbildspeicher notwendig und im Bildfrequenzaufwärtskonverter zur Flimmerbefreiung von HDTV-Signalen werden ein oder zwei Halbbildspeicher in einem hochaufgelösten Format benötigt.

Die genannten Anwendungen stellen unterschiedliche Anforderungen an einen HDTV-Bildspeicher. Bilddatenrate, Bildformate und Signal-Komponentenverhältnisse unterscheiden sich. Es sind auch unterschiedlich komplexe Adressierungsschemata üblich. Für bestimmte Anwendungen sind drei oder vier Datentore erwünscht.

Aus der DE-A-39 07 722 sowie der EP-A-0 386 841 ist eine integrierte Halbleiterspeicheranordnung mit einer Eingabe- und drei Ausgabeanordnungen bekannt. Die Eingabe- bzw. Ausgabeanordnungen sind jeweils mit einem Schieberegister zum seriellen Ein- bzw. Auslesen von Bildpunktdaten und mit diesen nach- bzw. vorgeschalteten Schreib- bzw. Lesespeichern gebildet. Die Übertragung der Daten von den Schreib- bzw. Lesespeichern zum bzw. vom Hauptspeicher geschieht über einen 256 Bit breiten Datenbus.

In der Eingabeanordnung und in einer der drei Ausgabeanordnungen werden die Daten mittels eines 32 Bit langen Schieberegisters derart umformatiert, daß sie mit einer Breite von 8 Bit in die Speicheranordnung ein- bzw. aus ihr ausgelesen werden können. In den beiden anderen Ausgabeanordnungen werden der 256 Bit breite Datenstrom des Hauptspeichers nur einem, beiden Ausgabeanordnungen zugeordneten Lesespeicher zugeleitet. Der Ausgangsdatenstrom dieses Lesespeichers wird in zwei, jeweils 128 Bit breite Datenströme aufgeteilt und den beiden Schieberegistern der beiden Ausgabeanordnungen zugeleitet. In diese, jeweils nur 16 Bit langen Schieberegister werden diese Datenströme in jeweils 8 Bit breite Datenströme umformatiert. Mittels eines speicherexternen Multiplexers können diese beiden Datenströme zu einem Datenstrom mit doppelter Datenrate zusammengeführt werden.

Diese Anordnung hat den Nachteil, daß sie fest verdrahtet ist, und somit deren Ausgabeanordnungen nur für ein 16x8 Bit Datenformat verwendet werden können.

Es ist zwar möglich, durch Zusammenschaltung zweier solcher Speicheranordnungen und Kombination jeweils einer Ausgabeanordnung der einen mit einer Ausgabeanordnung der anderen Speicheranordnung einen Datenstrom mit einem 16x16 Bit-Format zu erzeugen, jedoch ist diese Anordnung sehr aufwendig und umständlich.

In der EP-A-0 246 767 ist ein Halbleiterspeicher für Videodaten beschrieben, der einen Hauptspeicher umfaßt sowie eine Eingabeanordnung und zwei Ausgabeanordnungen. Die Eingabeanordnung umfaßt zwei Vorspeicher mit seriellem eingangsseitigem Zugriff und parallelem Ausgang, die über einen Umschalter wahlweise abwechselnd mit dem Hauptspeicher verbunden werden. Die Ausgabeanordnungen umfassen jeweils in entsprechender Weise einen Umschalter, über den Daten parallel je einem Vorspeicher zuführbar sind, der seriell ausgelesen wird. Die Ausgabeanordnungen sind dabei unabhängig voneinander asynchron steuerbar.

Der Erfindung liegt somit das Problem zugrunde, eine integrierte Halbleiterspeicheranordnung, insbesondere zur Anwendung eines Bildspeicher im HDTV-Fernsehen zu schaffen, die anwendungsspezifisch und reversibel konfigurierbar ist und dabei die Nachteile der bereits bekannten Speicheranordnung vermeidet.

Das Problem wird gelost durch eine integrierte Halbleiterspeicheranordnung nach den Merkmalen des Patentanspruchs 1, alternativ durch eine integrierte Halbleiterspeicheranordnung nach den Merkmalen des Patentanspruchs 2 oder alternativ durch eine integrierte Halbleiterspeicheranordnung nach den Merkmalen des Patentanspruchs 3.

In weiterer erfindungsgemäßer Ausgestaltung sind bei der integrierten Halbleiterspeicheranordnung in den Eingabeanordnungen und/oder in den Ausgabeanordnungen Schalter vorgesehen, die ein Betreiben unterschiedlicher Abschnitte der jeweiligen Schieberegister und Schreibspeicher der Eingabeanordnungen und/oder der jeweiligen Schieberegister und Lesespeicher der Ausgabeanordnungen ermöglichen.

Bei der erfindungsgemäßen Speicheranordnung können je nach Anwendungsfall eine oder mehrere der vorhandenen, jeweils mehrere Bit breiten Eingabe- und/oder Ausgabeanordnungen zu jeweils breiteren, beispielsweise doppelt so breiten, Eingabe- und/oder Ausgabeanordnungen zusammengeschaltet werden, wodurch ein höherer Datenfluß erreicht wird. Durch die Möglichkeit, jede der Eingabe- und Ausgabeanordnungen entweder für sich allein oder mit anderen zusammengeschaltet zu betreiben, wird eine hohe Flexibilität bezüglich der möglichen Anwendungen der Speicheranordnung erreicht. Die Kombination von Eingabe-und Ausgabeanordnungen kann dabei jederzeit wieder geändert werden, da sie über von außen an die Speicheranordnung angelegte Signale oder Pinbelegungen erfolgt. Durch ein beispielsweise 3 Bit langes Signal an einem externen Anschluß können also bis zu acht verschiedenen Kombinationen von Eingabe- und/oder Ausgabeanordnungen erreicht werden. Es ist aber auch möglich, die 3 Bit an drei verschiedene Anschlüsse in Form eines Signals oder als feste Belegung anzulegen.

In einer vorteilhaften Weiterbildung der erfindungsgemäßen Speicheranordnung ist jeder der Eingabe- und Ausgabeanordnungen ein Adreß- und ein Takteingang zugeordnet, wodurch die einzelnen Eingabe- und Ausgabeanordnungen asynchron betreibbar sind. Um Anschlußpins einzusparen, sind die Adreßeingänge vorzugsweise als serielle Eingänge ausgebildet. Zu diesem Zweck ist es natürlich nötig, Adreßspeicher vorzusehen.

Bei einer vorteilhaften Ausgestaltung der erfindungsgemäßen integrierten Halbleiterspeicheranordnung ist dem Hauptspeicher eine Reihendecodierschaltung und eine Zeilendecodierschaltung und außerdem jeder Eingabe- und Ausgabeanordnung ein Adreßzähler zugeordnet. Die Steuerschaltung steuert dabei den Datenzugriff von einer jeweiligen Eingabe- oder Ausgabeanordnung auf den Hauptspeicher wahlweise über an die Anschlußeingänge angelegte Adressen oder über die Adreßzähler, indem sie über zweite, den jeweiligen Eingabe-und/oder Ausgabeanordnungen zugeordnete, externe Anschlüsse ansteuerbar ist.

Zur weiteren Erhöhung der Flexibilität der Speicheranordnung ist in weiterer vorteilhafter Ausgestaltung zumindest eine der Eingabeanordnungen auch als Ausgabeanordnung betreibbar.

Wenn ein Bildpunkt beispielsweise eine Auflösung von 9 Bit hat und die Eingabe- und Ausgabeanordnungen somit eine Tiefe von neun Ebenen aufweisen, ergibt sich bei einer Länge des Schieberegisters von beispielsweise 32 Bit, die Größe eines, auf einmal in den Hauptspeicher zu übertragenden Datenblocks von 32x9 Bit. Ein solcher Datenblock kann durch eine erfindungsgemäße Weiterbildung der Speicheranordnung entweder durch wahlfreie Adressierung mittels an die Adreßeingänge angelegte Adressen oder durch inkrementale Adressierung über Adreßzähler, die jeder der Eingabe- oder Ausgabeanordnungen zugeordnet sind, in den Hauptspeicher eingelesen oder aus dem Hauptspeicher ausgelesen werden. Der Betriebsmodus kann durch Ansteuerung von den einzelnen Eingabe- und Ausgabeanordnungen zugeordneten Anschlüssen für jede Eingabe- oder Ausgabeanordnung einzeln eingestellt werden. Die Speicheranordnung kann also für einfache Verzögerungsfunktionen in einem FIFO-Modus arbeiten, es können aber auch Daten blockweise wahlfrei adressiert werden, wenn besondere Signalverarbeitungsfunktionen durchgeführt werden sollen. Die Anordnung der Datenblöcke im Speicher muß dabei nicht der Bildpunktanordnung auf dem Fernsehbildschirm entsprechen.

Zur Bestimmung des Betriebsmodus einer Eingabe- oder Ausgabeanordnung sind in einer möglichen Ausführungsform besondere Modusanschlüsse vorgesehen. Um Anschlüsse einzusparen, ist es jedoch von Vorteil, wenn die Betriebsmodi der einzelnen Eingabe- und Ausgabeanordnungen über an die Adreßeingänge angelegte Steuerbits eingestellt werden. Dazu wird beispielsweise an zumindest einen der Adreßeingänge ein Signal gelegt, durch dessen erstes Bit bestimmt wird, ob eine wahlfreie oder eine inkrementale Adressierung erfolgt und dessen nachfolgende Bits im Falle der wahlfreien Adressierung die Adresse enthalten und im Falle der inkrementalen Adressierung Steuerbits für die Adreßzähler enthalten.

Eine für heutige Ansprüche bezüglich Anwendungsmöglichkeiten und damit Konfigurierbarkeitsvielfalt ausreichende erfindungsgemäße integrierte Halbleiterspeicheranordnung ist durch eine Ausführungsform mit je zwei, jeweils paarweise zusammenschaltbaren Eingabe- und Ausgabeanordnungen gegeben, wobei eine der Eingabeanordnungen auch als Ausgabeanordnung betreibbar ist. Mit dieser Vier-Tor-Speicheranordnung läßt sich in erfindungsgemäßer Weise sowohl ein Zwei-Tor- als auch ein Drei-Tor-Speicher durch paarweises Zusammenschalten von Eingabe- und/oder Ausgabeanordnungen realisieren. Die einzelnen Tore sind dabei asynchron mit unterschiedlichen Takten und in unterschiedlichen Betriebsmodi betreibbar. Bei Reduzierung der Torzahl auf drei Tore sind auch unterschiedlich breite Tore vorhanden, so daß unterschiedliche Datenraten möglich sind. Beim Zusammenschalten von Eingabe- und/oder Ausgabeanordnungen werden diese mit dem Takt und dem Adreßeingang einer dieser Eingabe- und/oder Ausgabeanordnungen betrieben. Die Blockrate für die zusammengeschalteten Eingabe- und/oder Ausgabeanordnungen zugeordneten Schieberegister, d.h. also die Rate, mit der die Daten parallel vom Schieberegister in den Schreibspeicher bzw. vom Lesespeicher in das Schieberegister übergeben werden, erhöht sich um einen Faktor, der gleich der jeweiligen Anzahl zusammengeschalteter Eingabe und/oder Ausgabeanordnungen ist, so daß die Datenblockgröße beim Zusammenschalten von Eingabe- und/oder Ausgabeanordnungen gleich bleibt.

Beim Zusammenschalten von zwei Eingabeanordnungen mit einer Tiefe von 9 Bit und einer Länge von 32 Bit, woraus bei Einzelbetrieb eine Datenblockgröße von 32x9 Bit resultiert, ergibt sich also eine Datenblockgröße von 16x18 Bit bei doppelt so hoher Blockrate, was einer Verdopplung der effektiven Datenrate entspricht.

Die Erfindung soll nachfolgend anhand von Ausführungsbeispielen mit Hilfe von Figuren näher erläutert werden. Es zeigen dabei
- Figur 1: eine von beispielsweise neun Ebenen einer erfindungsgemäßen Speicheranordnung,
- Figur 2: eine weitere mögliche Ausführungsform von Eingabeanordnungen,
- Figur 3a bis 3e: mögliche Speicherkonfigurationen,
- Figuren 4 bis 7: mögliche zeitliche Abläufe bei Einstellung des Betriebsmodus über die Adreßeingänge.

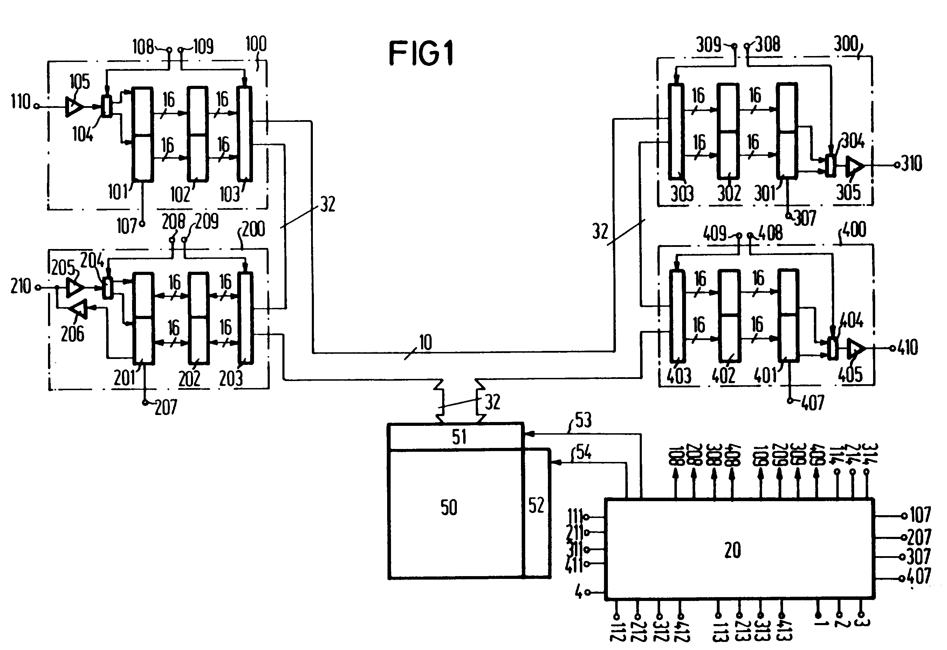

In Figur 1 ist eine mögliche, prinzipielle Ausführungsform einer von beispielsweise neun Ebenen einer erfindungsgemäßen Speicheranordnung dargestellt. Neun Ebenen würden der Auflösung eines Bildpunkts mit 9 Bit entsprechen, was bedeutet, daß in diesem Fall die Bildpunktauflösung um ein Bit größer wäre als bei bekannten Speicheranordnungen üblich ist. Es wäre aber auch denkbar, eines dieser neun Bit zur Übertragung von Zusatzinformation zu benutzen. Die dargestellte Speicheranordnung hat einen Hauptspeicher 50, dem eine Spaltendecodierschaltung 51 und eine Reihendecodierschaltung 52 zugeordnet sind. Der Datentransfer von und zum Hauptspeicher 50 erfolgt über einen 32 Bit breiten Datenbus 10. An diesem Datenbus 10 sind außerdem eine erste Eingabeanordnung 100 und eine zweite Eingabeanordnung 200, wobei die zweite Eingabeanordnung 200 auch als Ausgabeanordnung betreibbar ist, und eine erste Ausgabeanordnung 300 und eine zweite Ausgabeanordnung 400 angeschlossen. Eine Steuerschaltung 20 versorgt die Eingabe- und Ausgabeanordnungen 100 bis 400 sowie die Decodierschaltungen 51, 52 mit den für einen Lese- bzw. Schreibvorgang nötigen Signalen, wobei sie über externe Anschlüsse 1 bis 4, 107, 207, 307, 407, 111, 211, 311, 411, 112, 212, 312, 412, 113, 213, 313, 413, 214, 314, 414 angesteuert werden kann.

Die erste Eingabeanordnung 100 hat einen seriellen Dateneingang 110, an den eines von 9 Bit der seriell einzuschreibenden, einem Bildpunkt entsprechenden Datenworte angelegt wird. Die somit am Eingang 110 anliegende Bitfolge wird von einem Schreibverstärker 105 verstärkt und einem Schalter 104 zugeführt. Der Schalter 104 hat zwei Ausgänge, die einem Schieberegister 101 zugeführt werden. Dieses Schieberegister ist 32 Bit lang und in zwei Abschnitte zu je 16 Bit unterteilt, wobei jeder der beiden Abschnitte mit einem Ausgang des Schalters 104 verbunden ist. Jeder der beiden Abschnitte des Schieberegisters 101 ist über eine 16-polige Leitung mit jeweils einem von zwei Abschnitten eines Schreibspeichers 102 verbunden, so daß die sich im Schieberegister befindenden Daten parallel an den Schreibspeicher 102 übergeben werden können. Die beiden Abschnitte des Schreibspeichers 102 sind ihrerseits jeweils über eine 16-polige Leitung mit einer Schalteinrichtung 103 verbunden, die außerdem mit dem 32 Bit breiten Datenbus 10 verbunden ist.

Das Schieberegister 101 hat einen Anschluß 107, über den es von der Steuerschaltung 20 mit einem Taktsignal versorgt wird. Außerdem wird der Schalter 104 über einen Anschluß 108 und die Schaltungseinrichtung 103 über einen Anschluß 109 von der Steuerschaltung 20 gesteuert.

Die zweite Eingabeanordnung 200 ist fast identisch aufgebaut wie die erste Eingabeanordnung 100. Sie ist ebenfalls mit einem Dateneingang 210, einem Schreibverstärker 205, einem mit einem Anschluß 208 versehenen Schalter 204, einem mit einem Anschluß 207 versehenen Schieberegister 201, einem Schreibspeicher 202, und einer mit einem Anschluß 209 versehenen Schalteinrichtung 203 gebildet. Da sie jedoch auch als Ausgabeanordnung betreibbar sein soll, sind die 16-poligen Leitungen zwischen dem Schieberegister 201 und dem Schreibspeicher 202, sowie zwischen dem Schreibspeicher 202 und der Schalteinrichtung 203 bidirektional ausgebildet. Außerdem fungiert der Schreibspeicher 202 natürlich auch als Lesespeicher. Das Schieberegister 201 ist zusätzlich mit einem Ausgang versehen, der über einen Leseverstärker 206 mit dem, in diesem Fall auch als Datenausgang fungierenden Datenzugang 210 verbunden ist.

Die beiden Ausgabeanordnungen 300, 400 sind zueinander identisch aufgebaut. Auch sie haben jeweils eine mit einem Anschluß 309, 409 versehene Schalteinrichtung 303, 403, die sowohl mit dem Datenbus 10 als auch über zwei 16-polige Leitungen mit einem Lesespeicher 302, 402 verbunden ist. Die Lesespeicher 302, 402 sind jeweils über zwei 16-polige Leitungen mit je einem mit einem Anschluß 307, 407 versehenen Schieberegister 301, 401 verbunden. Diese Schieberegister 301, 401 sind mit jeweils zwei Ausgängen mit je einem mit jeweils einem Anschluß 308, 408 versehenen Schalter 304, 404 verbunden. Die Schalter 304, 404 sind jeweils über je einen Leseverstärker 305, 405 mit den jeweiligen Datenausgängen 310, 410 verbunden.

Zur Erläuterung eines Schreib- oder Lesevorgangs soll nun die Anschlußbelegung der Speicheranordnung beschrieben werden.

Wie bereits beschrieben, liegen an den Datenanschlüssen 110, 210, 310, 410 jeweils eines von beispielsweise neun Bit eines Datenworts an, wobei ein Datenwort einem Bildpunkt entspricht und die Bildpunkte seriell ein- bzw. ausgelesen werden.

Der Takt, mit den die Daten ein- bzw. ausgelesen werden, wird an die Taktanschlüsse 107, 207, 307, 407 angelegt. Speicherintern wird dieser Takt auch an die Schieberegister 101, 201, 301, 401 angelegt. Für jede Eingabe- bzw. Ausgabeanordnung 100 bis 400 ist ein eigener Taktanschluß 107...407 vorgesehen, so daß die Eingabe- und Ausgabeanordnungen 100...400 völlig asynchron und unabhängig voneinander betrieben werden können.

Über die Modusanschlüsse 111, 211, 311, 411 wird bestimmt, in welchem Betriebsmodus die einzelnen Eingabe- und Ausgabeanordnungen 100...400 arbeiten. Das bedeutet, daß durch an diese Anschlüsse 111...411 anliegende Signale bestimmt wird, ob die an den Datenzugängen 110...410 ein- bzw. auszulesenden Daten wahlfrei über an die Adreßanschlüsse 112, 212, 312, 412 angelegte Adressen adressiert werden, oder ob die Adressen mittels auf bekannte Weise in der Steuerschaltung 20 enthaltenen Adreßzählern - wobei jeder Eingabe- bzw. Ausgabeanordnung 100...400 ein eigener Adreßzähler zugeordnet ist - generiert werden sollen.

Die Adreßanschlüsse 112...412 sind serielle Adreßeingänge, wobei jeder Eingabe- bzw. Ausgabeanordnung 100...400 jeweils einer dieser Adreßanschlüsse zugeordnet ist. Die Adreßeingänge sind mit demselben Takt wie die jeweils zugehörigen Eingabe- bzw. Ausgabeanordnungen betreibbar. In der Steuerschaltung 20 sind in bekannter Weise Adreßspeicher enthalten, um die seriellen Adressen zwischenzuspeichern. Außerdem ist eine Adressendecodierschaltung enthalten, die die Spaltenadressen 53 und die Reihenadressen 54 für die Spaltendecodierschaltung 51 und die Reihendecodierschaltung 52 erzeugt.

Es ist prinzipiell auch möglich, parallele Adreßeingänge vorzusehen; das würde jedoch einen erheblich größeren Anschlußaufwand erfordern. Für den Fall einer nicht wahlfreien, sondern inkrementalen Adressierung über die Adreßzähler, können an die Adreßanschlüsse 112...412 die Steuersignale für die Adreßzähler angelegt werden.

Damit die Steuerschaltung 20 erkennt, wann eine im Fall der wahlfreien Adresssierung angelegte Adresse gültig ist, sind Zyklusanschlüsse 113, 213, 313, 413 vorgesehen, die mit entsprechenden Signalen beaufschlagt werden können. An diese Zyklusanschlüsse 113...413 können im Falle einer inkrementalen Adressierung aber auch die Rückstellsignale für die Adreßzähler angelegt werden.

Zur Bestimmung der jeweils gewünschten Konfiguration der Speicheranordnung sind Konfigurationsanschlüsse 1, 2, 3 vorgesehen. In diesem Ausführungsbeispiel sind drei Konfigurationsanschlüsse 1, 2, 3 gewählt, so daß maximal acht verschiedene Konfigurationsmöglichkeiten gegeben sind. Es können natürlich auch mehr oder weniger Konfigurationsanschlüsse vorgesehen werden, auch abhängig von der Anzahl der Eingabe- und Ausgabeanordnungen. Es ist außerdem natürlich ebensogut möglich, nur einen Konfigurationsanschluß vorzusehen, und die Konfigurationsbits seriell der Steuerschaltung zuzuführen.

Durch Signale, die an die Einschaltanschlüsse 214, 314, 414 der Steuerschaltung 20 angelegt werden können, werden die Ausgabeanordnungen 200, 300, 400 in den Lesebetrieb geschaltet und erhalten damit die Möglichkeit, auf den Hauptspeicher 50 zuzugreifen. Außerdem kann durch ein Signal am Einschaltanschluß 214, die sowohl als Eingabeals auch als Ausgabeanordnung betreibbare zweite Eingabeanordnung 200 in den jeweils gewünschten Zustand geschaltet werden.

Im folgenden soll nun zunächst erläutert werden, wie ein Schreibvorgang abläuft, wenn die erste Eingabeanordnung 100 separat arbeitet, also nicht mit der zweiten Eingabeanordnung 200 zusammengeschaltet ist.

Durch Signale an den Konfigurationsanschlüssen 1 bis 3 ist eine Konfiguration gewählt worden, bei der die erste Eingabeanordnung 100 separat arbeitet. Durch Signale an den Einschaltanschlüssen 214...414 der Steuereinrichtung 20 werden die zweite Eingabeanordnung 200 und die Ausgabeanordnungen 300, 400 in einen Zustand geschaltet, in dem sie nicht aus dem Hauptspeicher 50 lesen können. Über den Adreßanschluß 112 wird die serielle Adresse mittels eines am Taktanschluß 107 anliegenden Taktes eingelesen, wenn am Modusanschluß 111 ein Signal angelegt wurde, durch das wahlfreie Adressierung bestimmt wurde. Mit einem Signal am Zyklusanschluß 113 wird bestimmt, wann die eingegebene Adresse gültig sein soll. Gleichzeitig mit der Adresse werden am Dateneingang 110 die Daten über den Schreibverstärker 105 und den Schalter 104 in den ersten Abschnitt des Schieberegister 101, ebenfalls mit dem an dessen Taktanschluß 107 anliegenden Takt eingelesen. Der Schalter 104 ist mittels eines an seinem Anschluß 108 liegenden Signals mit dem ersten Abschnitt des Schieberegisters 101 verbunden. Wenn das Schieberegister 101 voll ist, werden die Daten parallel in den Schreibspeicher 102 übertragen, von dem sie mittels der Schalteinrichtung 103 in den Hauptspeicher 50 an die vorher eingegebene Adresse übertragen werden, wenn diese Schalteinrichtung 103 ein entsprechendes Signal an ihrem Anschluß 109 von der Steuerschaltung 20 erhält.

In äquivalenter Weise läuft ein Lesevorgang mit separat geschalteter Ausgabeanordnung 300 oder 400 ab, mit der Ausnahme, daß das Eingeben der Adresse und das Ausgeben der Daten am Datenausgang 310 oder 410 zeitlich versetzt erfolgt.

Sollen beispielsweise die beiden Eingabeanordnungen 100 und 200 zusammengeschaltet werden, so wird über Signale an den Anschlüssen 214...414 einerseits verhindert, daß die Ausgabeanordnungen 300, 400 auf den Hauptspeicher 50 zugreifen können und andererseits die zweite Eingabeanordnung 200 in den Schreibzustand geschaltet. Über Signale an den Konfigurationsanschlüssen 1 bis 3 wird die Steuerschaltung 20 veranlaßt, die Eingabeanordnungen 100, 200 gemeinsam zu betreiben. Das bedeutet, daß beiden Anordnungen 100, 200 jeweils ein gemeinsamer Taktanschluß 107, ein gemeinsamer Adreßanschluß 112, ein gemeinsamer Modusanschluß 111 und ein gemeinsamer Zyklusanschluß 113 zugeordnet ist. Über den Modusanschluß 111 sei wieder wahlfreie Adressierung gewählt worden. Das bedeutet, daß mittels eines am Takteingang 107 angelegten Taktsignals eine Adresse am Adreßeingang 112 eingegeben wird und mittels eines Signals am Zykluseingang 113 für gültig erklärt wird.

Gleichzeitig werden an den Dateneingängen 110, 210 der Eingabeanordnungen 100, 200 Daten über die Schreibverstärker 105, 205 und die Schalter 104, 204 in die Schieberegister 101, 201 eingegeben. Da über den Datenbus 10 nur 32 Bit parallel übertragen werden können, jedoch zwei Eingabeanordnungen 100, 200 zusammengeschaltet sind, müssen die Daten aus den Schieberegistern 101 und 102 mit der doppelten Blockrate, das heißt also bereits, wenn erst 16 Bit Daten in die Schieberegister 101, 201 eingegeben sind, in die Schreibspeicher 102, 202 übertragen werden. Die Daten können dann entweder in dem ersten oder in dem zweiten der beiden Abschnitte der Schieberegister 101, 201 stehen. Abhängig davon, ob bereits Daten in einem der beiden Abschnitte stehen, werden die Schalter 104, 204 über ihre Anschlüsse 108, 208 von der Steuerschaltung 20 so eingestellt, daß die in die Schieberegister 101, 201 einzuschreibenden Daten in die jeweils anderen Abschnitte eingeschrieben werden. Über die Schalteinrichtungen 103, 203, die über ihre Anschlüsse 109, 209 von der Steuerschaltung 20 angesteuert werden, werden dann entweder die Daten der beiden ersten Schreibspeicherabschnitte oder der beiden zweiten Schreibspeicherabschnitte gleichzeitig auf den Datenbus 10 gegeben, um unter einer Adresse im Hauptspeicher 50 abgespeichert zu werden. Für den Fall, daß die Daten immer so rechtzeitig von den ersten Schreibspeicherabschnitten in den Hauptspeicher 50 übernommen werden, daß die ersten Schreibspeicherabschnitte wieder frei sind, wenn die ersten Abschnitte der Schieberegister 101, 201 wieder gefüllt sind, kann auf die Schalter 104, 204 verzichtet werden.

In äquivalenter Weise folgt das Auslesen von Daten aus dem Hauptspeicher 50, wenn mittels einer geeigneten Bitkonfiguration an den Konfigurationsanschlüssen 1 bis 3 die beiden Ausgabeanordnungen 300, 400 zusammengeschaltet werden. Auch in diesem Fall sind ihnen jeweils ein gemeinsamer Modusanschluß 311, Taktanschluß 307, Adreßanschluß 312 und Zyklusanschluß 313 zugeordnet. Daten, die unter der am Adreßanschluß 312 eingelesenen Adresse im Hauptspeicher 50 abgespeichert sind, werden über den Datenbus 10 und die Schalteinrichtungen 303, 403 jeweils einem der beiden Abschnitte der Lesespeicher 302, 402 zugeführt. Wenn die Schieberegister 301, 401 leer sind, werden die Daten parallel aus den Lesespeichern 302, 402 übernommen und über die Schalter 304, 404 und die Leseverstärker 305, 405 an den Datenausgängen 310, 410 seriell ausgegeben. Die Schalter 304, 404 werden dabei von der Steuereinrichtung 20, abhängig davon, in welchem Abschnitt des Schieberegisters 301, 401 die Daten stehen, über die Schalteranschlüsse 309, 409 entsprechend eingestellt.

Die Datenrate ist dann bei gleicher Taktrate wie im Einzelbetrieb der Ausgabeanordnungen 300, 400 doppelt so hoch, allerdings in einem 16x18 Bit-Format statt in einem 32x9 Bit-Format bei Einzelbetrieb.

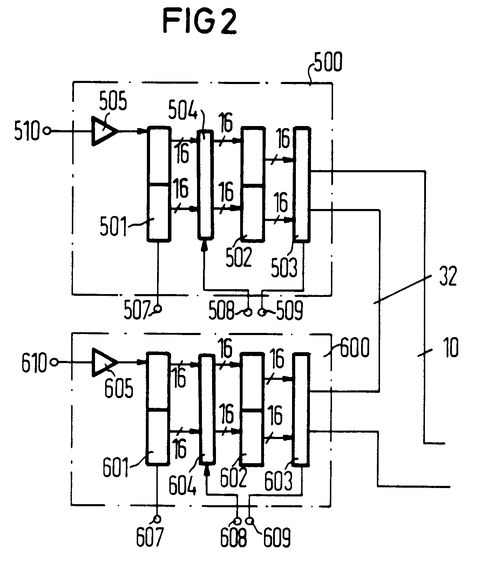

Eine weitere mögliche Ausführungsform der Eingabeanordnungen ist in Figur 2 dargestellt. Sie zeigt zwei Eingabeanordnungen 500, 600, die jeweils mit einem Schreibverstärker 505, 605, einem in zwei Abschnitte unterteilten Schieberegister 501, 601, einem in zwei Abschnitte unterteilten Schreibspeicher 502, 602, einer einen Anschluß 509, 609 aufweisenden Schalteinrichtung 503, 603 und einem einen Anschluß 508, 608 aufweisenden Schalter 504, 604 gebildet sind. Die Dateneingänge 510, 610 bilden dabei die Eingänge der Schreibverstärker 505, 605, deren Ausgänge jeweils mit dem ersten Abschnitt der Schieberegister 501, 601 verbunden sind. Die Schieberegister 501, 601 werden über Taktanschlüsse 507, 607 von einer nicht dargestellten Steuereinrichtung mit dem Takt versorgt. Die ersten und die zweiten Abschnitte der Schieberegister 501, 601 sind jeweils mit dem Schalter 504, 604 über jeweils 16-polige Leitungen verbunden. Die Schalter 504, 604 sind über jeweils 16-polige Leitungen sowohl mit den ersten als auch mit den zweiten Abschnitten der Schreibspeicher 502, 602 verbunden. Die Schreibspeicher 502, 602 sind über jeweils zwei 16-polige Leitungen mit den Schalteinrichtungen 503, 603 verbunden, die ihrerseits mit dem 32-poligen Datenbus 10 verbunden sind.

Bei dieser Ausführungsform werden bei zusammengeschalteten Eingabeanordnungen 500, 600 die Daten immer nur in die ersten Abschnitte der Schieberegister 501, 601 eingeschrieben, von wo sie über die Schalter 504, 604, abhängig von einem Signal an den Anschlüssen 508, 608 der Schalter 504, 604 entweder in die ersten oder die zweiten Abschnitte der Schreibspeicher 502, 602 übertragen werden. Das Signal an den Schalteranschlüssen 508, 608 kommt von der Steuereinrichtung, die ihrerseits beispielsweise über die Anschlüsse 509, 609 der Schalteinrichtungen 503, 603 abfragen kann, ob die ersten oder die zweiten Schreibspeicherabschnitte gefüllt oder leer sind. Auch in diesem Fall kann auf die Schalter 504, 604 verzichtet werden, wenn aufgrund rechtzeitiger Datenübertragungen von den Schreibspeichern 502, 602 in den Hauptspeicher 50 keine Datenkollision auftreten kann.

Die zweite Eingabeanordnung 600 ist in Figur 2 nur zum Schreiben ausgelegt, es ist jedoch selbstverständlich, daß sowohl diese als auch die erste Eingabeanordnung 500 mit einigen schaltungstechnischen Ergänzungen entsprechend der zweiten Eingabeanordnung 200 gemäß Figur 1 auch als Ausgabeanordnung betreibbar ist.

Die Ausführungsform der Eingabeanordnung gemäß Figur 2 kann natürlich auf einfache Weise auf die Ausgabeanordnung 300 oder 400 der Figur 1 übertragen werden. Die Schalter 304, 404 müssen dann auch zwischen den Lesespeichern 302, 402 und den Schieberegister 301, 401 angeordnet werden.

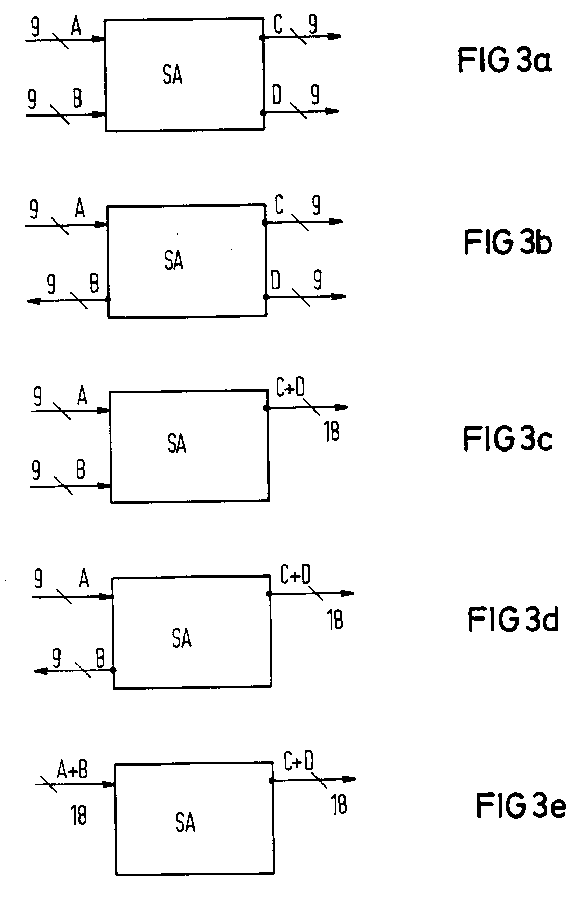

Einige mögliche sinnvolle Konfigurationsbeispiele werden durch die Figuren 3 a bis 3 e dargestellt. Es handelt sich dabei jeweils um Speicheranordnungen SA mit vier 9-poligen, seriellen Datenzugängen A, B, C, D. Der Datenzugang A ist als Eingabeanordnung, der Datenzugang B sowohl als Eingabe- als auch als Ausgabeanordnung, und die Datenzugänge C und D sind als Augabeanordnungen ausgeführt.

Figur 3 a zeigt den Fall, daß alle vier Datenzugänge A, B, C, D separat geschaltet sind und Zugang B als Eingabeanordnung ausgeführt ist. Diese Konfiguration ist sinnvoll, wenn die Speicheranordnung für zwei unabhängige Prozesse, die jeweils einen Speicher mit Ein- und Ausgang benötigen, benutzt werden sollen.

Die Konfiguration gemäß Figur 3 b zeigt ebenfalls vier separate Datenzugänge A, B, C, D, allerdings ist hier Zugang B als Ausgabeanordnung geschaltet.

In Figur 3 c sind die Datenzugänge C und D zusammengeschaltet, und der Zugang B ist als Eingabeanordnung ausgeführt. Die Konfiguration erlaubt beispielsweise eine Bild-In-Bild-Funktion bei gleichzeitiger Verdopplung der Bildfolgefrequenz, da die Datenrate an den zusammengeschalteten Zugängen C und D doppelt so hoch wie die der Zugänge A oder B ist, wobei die Schiebetaktrate der Zugänge A, B, C und D gleich groß bleiben kann.

Die Konfiguration gemäß Figur 3 d entspricht der gemäß Figur 3 c, nur daß hier der Zugang B als Ausgabeanordnung ausgeführt ist. Ein möglicher Anwendungsfall ist eine Bildfolgefrequenzverdopplung bei gleichzeitiger Möglichkeit zur Rauschreduktion über eine Rückkopplung des Zugangs B auf den Zugang A über eine spezielle Signalverarbeitungsschaltung.

In Figur 3 e ist der Zugang B als Eingabeanordnung geschaltet und mit dem Zugang A zusammengeschaltet. Auch die Zugänge C und D sind zusammengeschaltet.

Bei der Ausführungsform gemäß Figur 1 werden die Betriebsmodi der einzelnen Eingabe- und Ausgabeanordnungen 100...400 über Signale an den Modenanschlüssen 111...411 eingestellt. Wie bereits in der Einleitung angeführt, ist es aber auch möglich, diese Anschlüsse einzusparen und statt dessen Steuersignale für die Betriebsmodi über die Adreßanschlüsse 112...412 zusammen mit den Adressen der Steuerschaltung 20 zuzuführen.

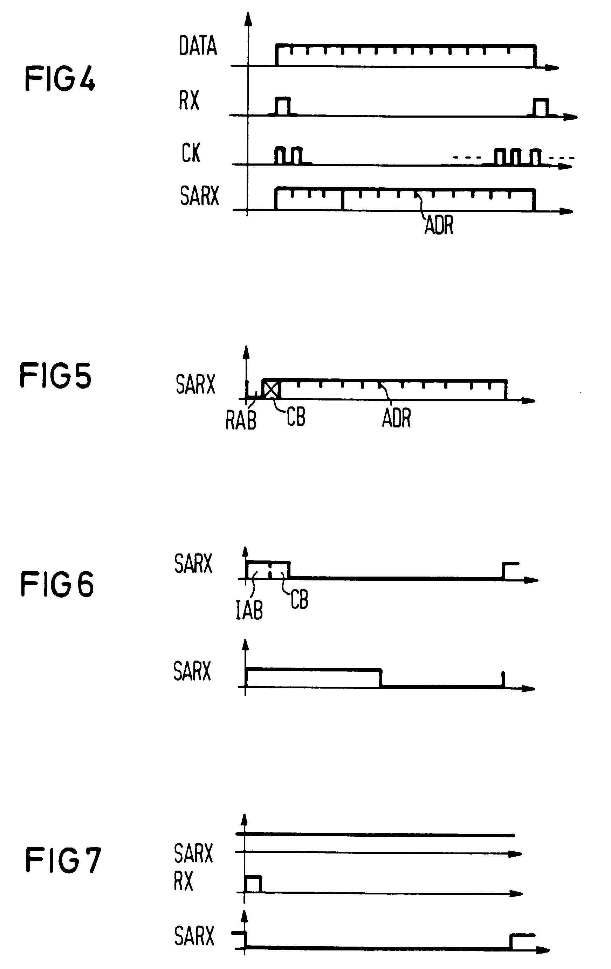

In Figur 4 ist anhand einiger Signalformen dargestellt, wie das prinzipiell ablaufen kann, wobei es hier mit einem Schreibvorgang erläutert werden soll. Ein Lesevorgang läuft natürlich äquivalent ab.
Mit einem Taktsignal CK werden sowohl serielle Daten DATA als auch ein serielles Adressignal SARX in ein Schieberegister bzw. in einen Adresspeicher eingelesen. Mit einem Signal RX, das an den Zyklusanschluß einer Steuereinrichtung angelegt wird, wird der Anfang und das Ende des Adressignals SARX bestimmt. Die Steuerbits, die zum Einstellen des Betriebsmodus nötig sind, befinden sich im Kopfteil des Adressignals SARX.

In Figur 5 ist dargestellt, wie das Adressignal SARX im Falle einer wahlfreien Adressierung aussehen könnte. Das erste Bit RAB des Signals SARX - in diesem Fall eine logische "Null" - bestimmt, daß es sich um wahlfreie Adressierung handelt. Daran anschließend kommt beispielsweise ein weiteres Steuerbit CB und daran anschließend die Adresse ADR.

Ein Beispiel für eine inkrementale Adressierung der Speicheranordnung ist in Figur 6 dargestellt. Zuerst wird ein Adressignal SARX an den Adreßeingang gelegt, dessen erstes Bit IAB hier eine logische "Eins" ist, danach kommt ein Steuerbit CB, das hier ebenfalls als logische "Eins" dargestellt ist, das prinzipiell aber beliebig sein kann. Daran anschließend kommt eine logische "Null" für alle weiteren Bit. Dieses Wort führt zur Erhöhung der Adresse um 1. Wird das im unteren Teil der Figur 6 dargestellte Signal an den Adreßeingang angelegt, wird der Adreßzähler zurückgesetzt. Wesentlich für dieses Signal ist, daß es wenigstens für die Dauer von zwei Taktspeichern eine logische "Eins" aufweist.

In Figur 7 ist eine zweite Möglichkeit der Einstellung für eine inkrementale Adressierung dargestellt. Hier wird an den Adreßanschluß ein Signal SARX angelegt, das ständig eine logische "Eins" aufweist, während gleichzeitig an den Zyklusanschluß ein Signal RX, das für die Dauer eines Bit, das eine logische "Eins" darstellt, angelegt wird. Dadurch wird die Steuerschaltung auf inkrementale Adressierung eingestellt. Eine Rücksetzung des Adreßzählers kann durch Anlegen einer logischen "Null" für eine geeignete Dauer erfolgen.

Diese Art der Adressensteuerung führt zu einfach zu erzeugenden Signalen SARX bei inkrementaler Adressierung. Beide Adressarten können in der Steuereinrichtung einfach und eindeutig decodiert werden.

Die erfindungsgemäße Speicheranordnung läßt sich in herkömmlicher Technologie aufbauen und ist mit unterschiedlich großem Hauptspeicher realisierbar. Vorzugsweise wird als Hauptspeicher ein DRAM-Speicher benutzt, bei dem die gespeicherten Daten mittels eines in Figur 1 dargestellten Refresh-Anschlusses 4 erhalten werden können.

## Patentansprüche

1. Integrierte Halbleiterspeicheranordnung zum Abspeichern der Bildpunktdaten eines Fernsehbildes
- mit einem Hauptspeicher (50),
- mindestens zwei Eingabeanordnungen (100, 200; S00, 600) und mindestens einer Ausgabeanordnung (300), die mit dem Hauptspeicher über einen Datenbus (10) verbunden sind, wobei
- die Eingabeanordnungen (100, 200; 500, 600) jeweils ein zumindest zwei Abschnitte umfassendes Schieberegister (101, 201; 501, 601) zum seriellen Einlesen der Bildpunktdaten, einen zumindest zwei Abschnitte umfassenden Schreibspeicher (102, 202; 502, 602) zur bitparallelen Übergabe der aus den jeweiligen Schieberegisterabschnitte gelesenen Daten an den Hauptspeicher (50) über den Datenbus (10) und eine Schalteinrichtung (103, 203; 503, 603) zur Steuerung dieser Datenübergabe an den Hauptspeicher (50) umfassen,
- jeweils eine der Eingabeanordnungen (100, 200; 500, 600) mit zumindest einer anderen der Eingabeanordnungen (100, 200; 500, 600) zusammenschaltbar ist, indem in den zusammengeschalteten Eingabeanordnungen (100, 200; 500, 600) die Schieberegister (101, 201; 501, 601) von einem gemeinsamen Takt ansteuerbar sind, die Bildpunktdaten in jeweils nur einen der Abschnitte der Schieberegister (101, 201; 501, 601) einlesbar sind und von den Schalteinrichtungen (103, 203; 503, 603) zueinander gleichzeitig auf den Datenbus (10) ausgebbar sind,
- die Ausgabeanordnung (300) ein zumindest zwei Abschnitte umfassendes Schieberegister (301, 401) zum seriellen Auslesen der Bildpunktdaten, einen zumindest zwei Abschnitte umfassenden Lesespeicher (302, 402) zur bitparallelen Übernahme der Daten aus dem Hauptspeicher (50) über den Datenbus (10) und zur Übergabe der Daten an die jeweiligen Schieberegisterabschnitte und eine Schalteinrichtung (303, 403) zum Steuern dieser Datenübernahme vom Hauptspeicher (50) umfaßt,
- und mit einer Steuerschaltung (20), die den Datenfluß zwischen den Eingabeanordnungen (100, 200; 500, 600) und der Ausgabeanordnung (300) und dem Hauptspeicher (50) steuert, und die die Zusammenschaltung jeweiliger Eingabeanordnungen (100, 200; 500, 600) steuert, indem sie über zumindest einen ersten externen Anschluß (1, 2, 3) ansteuerbar ist.

2. Integrierte Halbleiterspeicheranordnung zum Abspeichern der Bildpunktdaten eines Fernsehbildes
- mit einem Hauptspeicher (50),
- mindestens einer Eingabeanordnung (100; 500) und mindestens zwei Ausgabeanordnungen (300, 400), die mit dem Hauptspeicher über einen Datenbus (10) verbunden sind, wobei
- die Eingabeanordnung (100; 500) jeweils ein zumindest zwei Abschnitte umfassendes Schieberegister (101, 201; 501, 601) zum seriellen Einlesen der Bildpunktdaten, einen zumindest zwei Abschnitte umfassenden Schreibspeicher (102, 202; 502, 602) zur bitparallelen Übergabe der aus den jeweiligen Schieberegisterabschnitten gelesenen Daten an den Hauptspeicher (50) über den Datenbus (10) und eine Schalteinrichtung (103, 203; 503, 603) zur Steuerung dieser Datenübergabe an den Hauptspeicher (50) umfaßt,
- die Ausgabeanordnungen (300, 400) jeweils ein zumindest zwei Abschnitte umfassendes Schieberegister (301, 401) zum seriellen Auslesen der Bildpunktdaten, einen zumindest zwei Abschnitte umfassenden Lesespeicher (302, 402) zur bitparallelen Übernahme der Daten aus dem Hauptspeicher (50) über den Datenbus (10) und zur Übergabe der Daten an die jeweiligen Schieberegisterabschnitte und eine Schalteinrichtung (303, 403) zum Steuern dieser Datenübernahme vom Hauptspeicher (50) umfassen und wobei
- jeweils eine der Ausgabeanordnungen (300, 400) mit zumindest einer anderen der Ausgabeanordnungen (300, 400) zusammenschaltbar ist, indem in den zusammengeschalteten Ausgabeanordnungen (300, 400) die Schieberegister (301, 401) von einem gemeinsamen Takt ansteuerbar sind, die Bildpunktdaten vom Datenbus (10) über die Schalteinrichtungen (303, 403) zueinander gleichzeitig abgreifbar und in jeweils einen der Abschnitte der Schieberegister (301, 401) einlesbar sind,
- und mit einer Steuerschaltung (20), die den Datenfluß zwischen der Eingabeanordnung (100; 500) und den Ausgabeanordnungen (300, 400) und dem Hauptspeicher (50) steuert, und die die Zusammenschaltung jeweiliger Ausgabeanordnungen (300, 400) steuert, indem sie über zumindest einen ersten externen Anschluß (1, 2, 3) ansteuerbar ist.

3. Integrierte Halbleiterspeicheranordnung zum Abspeichern der Bildpunktdaten eines Fernsehbildes
- mit einem Hauptspeicher (50),
- mindestens zwei Eingabeanordnungen (100, 200; 500, 600) und mindestens zwei Ausgabeanordnungen (300, 400), die mit dem Hauptspeicher über einen Datenbus (10) verbunden sind, wobei
- die Eingabeanordnungen (100, 200; 500, 600) jeweils ein zumindest zwei Abschnitte umfassendes Schieberegister (101, 201; 501, 601) zum seriellen Einlesen der Bildpunktdaten, einen zumindest zwei Abschnitte umfassenden Schreibspeicher (102, 202; 502, 602) zur bitparallelen Übergabe der aus den jeweiligen Schieberegisterabschnitten gelesenen Daten an den Hauptspeicher (50) über den Datenbus (10) und eine Schalteinrichtung (103, 203; 503, 603) zur Steuerung dieser Datenübergabe an den Hauptspeicher (50) umfassen,
- jeweils eine der Eingabeanordnungen (100, 200; 500, 600) mit zumindest einer anderen der Eingabeanordnungen (100, 200; 500, 600) zusammenschaltbar ist, indem in den zusammengeschalteten Eingabeanordnungen (100, 200; 500, 600) die Schieberegister (101, 201; 501, 601) von einem gemeinsamen Takt ansteuerbar sind, die Bildpunktdaten in jeweils nur einen der Abschnitte der Schieberegister (101, 201; 501, 601) einlesbar sind und von den Schalteinrichtungen (103, 203; 503, 603) zueinander gleichzeitig auf den Datenbus (10) ausgebbar sind,
- die Ausgabeanordnungen (300, 400) jeweils ein zumindest zwei Abschnitte umfassendes Schieberegister (301, 401) zum seriellen Auslesen der Bildpunktdaten, einen zumindest zwei Abschnitte umfassenden Lesespeicher (302, 402) zur bitparallelen Übernahme der Daten aus dem Hauptspeicher (50) über den Datenbus (10) und zur Übergabe der Daten an die jeweiligen Schieberegisterabschnitte und eine Schalteinrichtung (303, 403) zum Steuern dieser Datenübernahme vom Hauptspeicher (50) umfassen und wobei
- jeweils eine der Ausgabeanordnungen (300, 400) mit zumindest einer anderen der Ausgabeanordnungen (300, 400) zusammenschaltbar ist, indem in den zusammengeschalteten Ausgabeanordnungen (300, 400) die Schieberegister (301, 401) von einem gemeinsamen Takt ansteuerbar sind, die Bildpunktdaten vom Datenbus (10) über die Schalteinrichtungen (303, 403) zueinander gleichzeitig abgreifbar und in jeweils einen der Abschnitte der Schieberegister (301, 401) einlesbar sind,
- und mit einer Steuerschaltung (20), die den Datenfluß zwischen den Eingabeanordnungen (100, 200; 500, 600) und den Ausgabeanordnungen (300, 400) und dem Hauptspeicher (50) steuert, und die die Zusammenschaltung jeweiliger Eingabeanordnungen (100, 200; 500, 600) und Ausgabeanordnungen (300, 400) steuert, indem sie über zumindest einen ersten externen Anschluß (1, 2, 3) ansteuerbar ist.

4. Integrierte Halbleiterspeicheranordnung nach einem der Ansprüche 1 bis 3, bei der in den Eingabeanordnungen (100, 200; 500, 600) und/oder in den Ausgabeanordnungen (300, 400) Schalter (104, 204; 504, 604; 304, 404) vorgesehen sind, die ein Betreiben unterschiedlicher Abschnitte der jeweiligen Schieberegister (101, 201; 501, 601) und Schreibspeicher (102, 202; 502, 602) der Eingabeanordnungen (100, 200; 500, 600) und/oder der jeweiligen Schieberegister (301, 401) und Lesespeicher (302, 402) der Ausgabeanordnungen (300, 400) ermöglichen.

5. Integrierte Halbleiterspeicheranordnung nach einem der Ansprüche 1 bis 4, bei der jeder der Eingabe- und Ausgabeanordnungen (100...400) jeweils ein Adreßeingang (112, 212, 312, 412) und ein Takteingang (107, 207, 307, 407) zugeordnet ist, wobei die Eingabe-und Ausgabeanordnungen (100... 400) asynchron betreibbar sind.

6. Integrierte Halbleiterspeicheranordnung nach Anspruch 5, bei der die Adreßeingänge (112, 212, 312, 412) serielle Eingänge sind und mit dem selben Takt wie die jeweils zugehörigen Eingabe-bzw. Ausgabeanordnungen (100...400) betreibbar sind.

7. Integrierte Halbleiterspeicheranordnung nach einem der Ansprüche 5 oder 6,
bei der dem Hauptspeicher (50) eine Spaltendecodierschaltung (52) und eine Zeilendecodierschaltung (51) zugeordnet ist,
bei der jeder der Eingabeanordnungen (100, 200) und Ausgabeanordnungen (300, 400) jeweils ein Adreßzähler zugeordnet ist,
und bei der die Steuerschaltung (20) den Datenzugriff von einer jeweiligen Eingabeanordnung (100, 200) und/oder Ausgabeanordnung (300, 400) auf den Hauptspeicher (50) wahlweise über an die Adresseingänge (112...412) angelegte Adressen oder über die Adreßzähler steuert, indem sie über zweite, den jeweiligen Eingabe und/oder Ausgabeanordnungen (100...400) zugeordnete, externe Anschlüsse (111, 211, 311, 411) ansteuerbar ist.

8. Integrierte Halbleiterspeicheranordnung nach einem der Ansprüche 1 bis 7, bei der zumindest eine Eingabeanordnung (200) auch als Ausgabeanordnung betreibbar ist.

9. Integrierte Halbleiterspeicheranordnung nach einem der Ansprüche 7 oder 8, bei der die zweiten externen Anschlüsse durch Modusanschlüsse (111, 211, 311, 411) gebildet sind, durch deren Beschaltung der Betriebsmodus der jeweiligen Eingabe und/oder Ausgabeanordnung (100...400) bestimmbar ist.

10. Integrierte Halbleiterspeicheranordnung nach einem der Ansprüche 7 oder 8, bei der die zweiten externen Anschlüsse durch die Adreßeingänge (112, 212, 312, 412) gebildet sind, und bei der der Betriebsmodus der jeweiligen Eingabe- und/oder Ausgabeanordnungen (100...400) durch an die Adreßeingänge (112, 212, 312, 412) angelegte Steuerbits einstellbar ist.

11. Integrierte Halbleiterspeicheranordnung nach einem der Ansprüche 3 bis 10, mit je zwei, jeweils zusammenschaltbaren Eingabeanordnungen (100, 200) und Ausgabeanordnungen (300, 400), wobei eine Eingabeanordnung (200) auch als Ausgabeanordnung betreibbar ist.

## Claims

1. Integrated semiconductor memory arrangement for storing the pixel data of a television picture
- having a main memory (50),
- at least two input arrangements (100, 200; 500, 600) and at least one output arrangement (300), which are connected to the main memory via a data bus (10), in which case
- the input arrangements (100, 200; 500, 600) in each case comprise a shift register (101, 201; 501, 601), which comprises at least two sections, for the serial read-in of the pixel data, a write memory (102, 202; 502, 602), which comprises at least two sections, for the bit-parallel transfer of the data read from the respective shift register sections to the main memory (50) via the data bus (10), and a switching device (103, 203; 503, 603) for controlling this data transfer to the main memory (50),
- in each case one of the input arrangements (100, 200; 500, 600) can be interconnected with at least one other of the input arrangements (100, 200; 500, 600), in that, in the interconnected input arrangements (100, 200; 500, 600), the shift registers (101, 201; 501, 601) can be driven by a common clock signal, the pixel data can be read into in each case only one of the sections of the shift registers (101; 201; 501, 601) and can be output by the switching devices (103, 203; 503, 603) mutually simultaneously onto the data bus (10),
- the output arrangement (300) comprises a shift register (301, 401), which comprises at least two sections for the serial read-out of the pixel data, a read memory (302, 402), which comprises at least two sections, for the bit-parallel acceptance of the data from the main memory (50) via the data bus (10) and for the transfer of the data to the respective shift register sections, and a switching device (303, 403) for controlling this acceptance of data from the main memory (50),
- and having a control circuit (20), which controls the data flow between the input arrangements (100, 200; 500, 600) and the output arrangement (300) and the main memory (50) and which controls the interconnection of respective input arrangements (100, 200; 500, 600) in that it can be driven via at least one first external terminal (1, 2, 3).

2. Integrated semiconductor memory arrangement for storing the pixel data of a television picture
- having a main memory (50),
- at least one input arrangement (100; 500) and at least two output arrangements (300, 400), which are connected to the main memory via a data bus (10), in which case
- the input arrangement (100; 500) comprises in each case one shift register (101, 201; 501, 601), which comprises at least two sections, for the serial read-in of the pixel data, a write memory (102, 202; 502, 602), which comprises at least two sections, for the bit-parallel transfer of the data read from the respective shift register sections to the main memory (50) via the data bus (10), and a switching device (103, 203; 503, 603) for controlling this data transfer to the main memory (50),
- the output arrangements (300, 400) in each case comprise a shift register (301, 401), which comprises at least two sections, for the serial read-out of the pixel data, a read memory (302, 402), which comprises at least two sections, for the bit-parallel acceptance of the data from the main memory (50) via the data bus (10) and for the transfer of the data to the respective shift register sections, and a switching device (303, 403) for controlling this acceptance of data from the main memory (50), and in which case
- in each case one of the output arrangements (300, 400) can be interconnected with at least one other of the output arrangements (300, 400) in that, in the interconnected output arrangements (300, 400), the shift registers (301, 401) can be driven by a common clock signal, the pixel data can be picked off mutually simultaneously from the data bus (10) via the switching devices (303, 403) and can be read into in each case one of the sections of the shift registers (301, 401),
- and having a control circuit (20), which controls the data flow between the input arrangement (100; 500) and the output arrangements (300, 400) and the main memory (50) and which controls the interconnection of respective output arrangements (300, 400) in that it can be driven via at least one first external terminal (1, 2, 3).

3. Integrated semiconductor memory arrangement for storing the pixel data of a television picture
- having a main memory (50),
- at least two input arrangements (100, 200; 500, 600) and at least two output arrangements (300, 400), which are connected to the main memory via a data bus (10), in which case
- the input arrangements (100, 200; 500, 600) in each case comprise a shift register (101, 201; 501, 601), which comprises at least two sections, for the serial read-in of the pixel data, a write memory (102, 202; 502, 602), which comprises at least two sections, for the bit-parallel transfer of the data read from the respective shift register sections to the main memory (50) via the data bus (10), and a switching device (103, 203; 503, 603) for controlling this data transfer to the main memory (50),
- in each case one of the input arrangements (100, 200; 500, 600) can be interconnected with at least one other of the input arrangements (100, 200; 500, 600) in that, in the interconnected input arrangements (100, 200; 500, 600), the shift registers (101, 201; 501, 601) can be driven by a common clock signal, the pixel data can be read into in each case only one of the sections of the shift registers (101, 201; 501, 601) and can be output by the switching devices (103, 203; 503, 603) mutually simultaneously onto the data bus (10),
- the output arrangements (300, 400) in each case comprise a shift register (301, 401), which comprises at least two sections, for the serial read-out of the pixel data, a read memory (302, 402), which comprises at least two sections, for the bit-parallel acceptance of the data from the main memory (50) via the data bus (10) and for the transfer of the data to the respective shift register sections, and a switching device (303, 403) for controlling this acceptance of data from the main memory (50), and in which case
- in each case one of the output arrangements (300, 400) can be interconnected with at least one other of the output arrangements (300, 400) in that, in the interconnected output arrangements (300, 400), the shift registers (301, 401) can be driven by a common clock signal, the pixel data can be picked off mutually simultaneously from the data bus (10) via the switching devices (303, 403) and can be read into in each case one of the sections of the shift registers (301, 401),
- and having a control circuit (20), which controls the data flow between the input arrangements (100, 200; 500, 600) and the output arrangements (300, 400) and the main memory (50) and which controls the interconnection of respective input arrangements (100, 200; 500, 600) and output arrangements (300, 400) in that it can be driven via at least one first external terminal (1, 2, 3).

4. Integrated semiconductor memory arrangement according to one of Claims 1 to 3, in which switches (104, 204; 504, 604; 304, 404) are provided in the input arrangements (100, 200; 500, 600) and/or in the output arrangements (300, 400), which switches permit operation of different sections of the respective shift registers (101, 201; 501, 601) and write memories (102, 202; 502, 602) of the input arrangements (100, 200; 500, 600) and/or of the respective shift registers (301, 401) and read memories (302, 402) of the output arrangements (300, 400).

5. Integrated semiconductor memory arrangement according to one of Claims 1 to 4, in which an address input (112, 212, 312, 412) and a clock signal input (107, 207, 307, 407) are respectively assigned to each of the input and output arrangements (100...400), it being possible to operate the input and output arrangements (100...400) asynchronously.

6. Integrated semiconductor memory arrangement according to Claim 5, in which the address inputs (112, 212, 312, 412) are serial inputs and can be operated with the same clock signal as the respectively associated input and output arrangements (100...400).

7. Integrated semiconductor memory arrangement according to either of Claims 5 and 6,
in which a column decoding circuit (52) and a row decoding circuit (51) are assigned to the main memory (50),
in which an address counter is respectively assigned to each of the input arrangements (100, 200) and output arrangements (300, 400),
and in which the control circuit (20) controls the data access from a respective input arrangement (100, 200) and/or output arrangement (300, 400) to the main memory (50) alternatively by means of addresses applied to the address inputs (112...412) or via the address counters in that it can be driven via second external terminals (111, 211, 311, 411) assigned to the respective input and/or output arrangements (100...400).

8. Integrated semiconductor memory arrangement according to one of Claims 1 to 7, in which at least one input arrangement (200) can also be operated as an output arrangement.

9. Integrated semiconductor memory arrangement according to either of Claims 7 and 8, in which the second external terminals are formed by mode terminals (111, 211, 311, 411), by means of whose connection configuration the operating mode of the respective input and/or output arrangement (100...400) can be determined.

10. Integrated semiconductor memory arrangement according to either of Claims 7 and 8, in which the second external terminals are formed by the address inputs (112, 212, 312, 412), and in which the operating mode of the respective input and/or output arrangements (100...400) can be set by control bits applied to the address inputs (112, 212, 312, 412).

11. Integrated semiconductor memory arrangement according to one of Claims 3 to 10, having in each case two respectively interconnectable input arrangements (100, 200) and output arrangements (300, 400), it being possible to operate one input arrangement (200) as an output arrangement as well.

## Revendications

1. Dispositif intégré de mémoire à semiconducteur servant à mettre en mémoire les données d'éléments d'image d'une image de télévision,
- comportant une mémoire (50) principale,
- au moins deux dispositifs (100, 200; 500, 600) d'entrée et au moins un dispositif (300) de sortie qui sont reliés à la mémoire principale par l'intermédiaire d'un bus (10) de données,
- les dispositifs (100, 200; 500, 600) d'entrée comprenant chacun un registre (101, 201; 501, 601) à décalage comportant au moins deux parties et servant à écrire en série les données des éléments d'image, une mémoire (102, 202; 502, 602) d'écriture comportant au moins deux parties et servant à transférer en bits parallèles les données lues dans les parties des registres à décalage associées à la mémoire (50) principale par l'intermédiaire du bus (10) de données, et un dispositif (103; 203; 503, 603) de commutation servant à commander ce transfert de données à la mémoire (50) principale,
- l'un des dispositifs (100, 200; 500, 600) d'entrée pouvant être interconnecté à au moins un autre des dispositifs (100, 200; 500, 600) d'entrée, du fait que, dans les dispositifs (100, 200; 500, 600) d'entrée interconnectés, les registres (101, 201; 501, 601) à décalage peuvent être commandés par une cadence commune, les données des éléments d'image ne peuvent être écrites que dans l'une des parties de chaque registre (101, 201; 501, 601) à décalage et peuvent être sorties par les dispositifs (103; 203; 503, 603) de commutation simultanément les unes par rapport aux autres sur le bus (10) de données,
- le dispositif (300) de sortie comprenant un registre (301, 401) à décalage comportant au moins deux parties et servant à lire en série les données des éléments d'images, une mémoire (302, 402) de lecture, comportant au moins deux parties, servant à prendre en charge en bits parallèles les données dans la mémoire (50) principale par l'intermédiaire du bus (10) de données et servant à transférer les données aux parties des registres à décalage associées, et un dispositif (303, 403) de commutation pour commander cette prise en charge de données de la mémoire (50) principale,
- et comportant au moins un circuit (20) de commande qui commande le flux de données entres les dispositifs (100, 200; 500, 600) d'entrée et le dispositif (300) de sortie et la mémoire (50) principale et qui commande l'interconnexion de dispositifs (100, 200; 500, 600) d'entrée associés par le fait qu'il peut être commandé par l'intermédiaire d'au moins une première borne (1, 2, 3) externe.

2. Dispositif intégré de mémoire à semiconducteur servant à mettre en mémoire les données d'éléments d'image d'une image de télévision,
- comportant une mémoire (50) principale,
- au moins un dispositif (100; 500) d'entrée et au moins deux dispositifs (300, 400) de sortie qui sont reliés à la mémoire principale par l'intermédiaire d'un bus (10) de données,
- le dispositif (100; 500) d'entrée comprenant un registre (101, 201; 501, 601) à décalage comportant au moins deux parties et servant à écrire en série les données des éléments d'image, une mémoire (102, 202; 502, 602) d'écriture comportant au moins deux parties et servant à transférer en bits parallèles les données lues dans les parties des registres à décalage associées à la mémoire (50) principale par l'intermédiaire du bus (10) de données, et un dispositif (103; 203; 503, 603) de commutation servant à commander ce transfert de données à la mémoire (50) principale,
- les dispositifs (300, 400) de sortie comprenant chacun un registre (301, 401) à décalage comportant au moins deux parties et servant à lire en série les données des éléments d'images, une mémoire (302, 402) de lecture, comportant au moins deux parties, servant à prendre en charge en bits parallèles les données dans la mémoire (50) principale par l'intermédiaire du bus (10) de données et servant à transférer les données aux parties des registres à décalage associées, et un dispositif (303, 403) de commutation pour commander cette prise en charge de données de la mémoire (50) principale,
- l'un des dispositifs (300, 400) de sortie pouvant être interconnecté à au moins un autre des dispositifs (300, 400) de sortie, du fait que, dans les dispositifs (300, 400) de sortie interconnectés, les registres (301, 401) à décalage peuvent être commandés par une cadence commune, les données des éléments d'image peuvent être prises simultanément les unes par rapport aux autres par le bus (10) de données par l'intermédiaire des dispositifs (303, 403) de commutation et écrites dans l'une des parties de chaque registre (301, 401) à décalage,
- et comportant au moins un circuit (20) de commande qui commande le flux de données entre le dispositif (100; 500) d'entrée et les dispositifs (300, 400) de sortie et la mémoire (50) principale et qui commande l'interconnexion de dispositifs (300, 400) de sortie associés par le fait qu'il peut être commandé par l'intermédiaire d'au moins une première borne (1, 2, 3) externe.

3. Dispositif intégré de mémoire à semiconducteur servant à mettre en mémoire les données d'éléments d'image d'une image de télévision,
- comportant une mémoire (50) principale,
- au moins deux dispositifs (100, 200; 500, 600) d'entrée et au moins deux dispositifs (300, 400) de sortie qui sont reliés à la mémoire principale par l'intermédiaire d'un bus (10) de données,
- les dispositifs (100, 200; 500, 600) d'entrée comprenant chacun un registre (101, 201; 501, 601) à décalage comportant au moins deux parties et servant à écrire en série les données des éléments d'image, une mémoire (102, 202; 502, 602) d'écriture comportant au moins deux parties et servant à transférer en bits parallèles, les données lues dans les parties des registres à décalage associées, à la mémoire (50) principale par l'intermédiaire du bus (10) de données, et un dispositif (103; 203; 503, 603) de commutation servant à commander ce transfert de données à la mémoire (50) principale,
- l'un des dispositifs (100, 200; 500, 600) d'entrée pouvant être interconnecté à au moins un autre des dispositifs (100, 200; 500, 600) d'entrée, du fait que, dans les dispositifs (100, 200; 500, 600) d'entrée interconnectés, les registres (101, 201; 501, 601) à décalage peuvent être commandés par une cadence commune, les données des éléments d'image ne peuvent être écrites que dans l'une des parties de chaque registre (101, 201; 501, 601) à décalage et peuvent être sorties par les dispositifs (103; 203; 503, 603) de commutation simultanément les unes par rapport aux autres sur le bus (10) de données,
- les dispositifs (300, 400) de sortie comprenant chacun un registre (301, 401) à décalage comportant au moins deux parties et servant à lire en série les données des éléments d'images, une mémoire (302, 402) de lecture, comportant au moins deux parties, servant à prendre en charge en bits parallèles les données dans la mémoire (50) principale par l'intermédiaire du bus (10) de données et servant à transférer les données aux parties des registres à décalage associées, et un dispositif (303, 403) de commutation pour commander cette prise en charge des données de la mémoire (50) principale,
- l'un des dispositifs (300, 400) de sortie pouvant être interconnecté à au moins un autre des dispositifs (300, 400) de sortie, du fait que, dans les dispositifs (300, 400) de sortie interconnectés, les registres (301, 401) à décalage peuvent être commandés par une cadence commune, les données des éléments d'image peuvent être prises simultanément les unes par rapport aux autres par le bus (10) de données par l'intermédiaire des dispositifs (303, 403) de commutation et écrites dans l'une des parties de chaque registre (301, 401) à décalage,
- et comportant au moins un circuit (20) de commande qui commande le flux de données entre les dispositifs (100, 200; 500, 600) d'entrée et les dispositifs (300, 400) de sortie et la mémoire (50) principale et qui commande l'interconnexion de dispositifs (100, 200; 500, 600) d'entrée et de dispositifs (300, 400) de sortie associés par le fait qu'il peut être commandé par l'intermédiaire d'au moins une première borne (1, 2, 3) externe.

4. Dispositif intégré de mémoire à semiconducteur suivant l'une des revendications 1 à 3, dans lequel il est prévu dans les dispositifs (100, 200; 500, 600) d'entrée et/ou dans les dispositifs (300, 400) de sortie des commutateurs (104, 204; 504, 604; 304, 404) qui permettent de faire fonctionner des parties différentes des registres (101, 201; 501, 601) à décalage associés et des mémoires (102, 202; 502, 602) d'écriture des dispositifs (100, 200; 500, 600) d'entrée et/ou des registres (301, 401) à décalage associés et des mémoires (302, 402) de lecture des dispositifs (300, 400) de sortie.

5. Dispositif intégré de mémoire à semiconducteur suivant l'une des revendications 1 à 4, dans lequel il est associé à chacun des dispositifs (100... 400) d'entrée et/ou de sortie une entrée (112, 212, 312, 412) d'adresses et une entrée (107, 207, 307, 407) de cadence, les dispositifs (100... 400) d'entrée et/ou de sortie pouvant fonctionner de manière asynchrone.

6. Dispositif intégré de mémoire à semiconducteur suivant la revendication 5, dans lequel les entrées (112, 212, 312, 412) d'adresses sont des entrées en série et peuvent fonctionner à la même cadence que les dispositifs (100... 400) d'entrée et/ou de sortie associés.

7. Dispositif intégré de mémoire à semiconducteur suivant l'une des revendications 5 ou 6,
dans lequel il est associé à la mémoire (50) principale un circuit (52) de décodage de colonnes et un circuit (51) de décodage de lignes,
dans lequel il est associé à chacun des dispositifs (100, 200) d'entrée et à chacun des dispositifs (300, 400) de sortie un compteur d'adresses
et dans lequel le circuit (20) de commande commande l'accès d'un dispositif (100, 200) d'entrée associé et/ou d'un dispositif (300, 400) de sortie aux données de la mémoire (50) principale au choix par l'intermédiaire d'adresses appliquées aux entrées (112.. 412) d'adresses ou par l'intermédiaire des compteurs d'adresses, du fait qu'il peut être commandé par l'intermédiaire de deuxièmes bornes (111, 211, 311, 411) externes associées aux dispositifs (100... 400) d'entrée et/ou de sortie associés.

8. Dispositif intégré de mémoire à semiconducteur suivant l'une des revendications 1 à 7, dans lequel on peut faire fonctionner au moins un dispositif (200) d'entrée aussi comme dispositif de sortie.

9. Dispositif intégré de mémoire à semiconducteur suivant l'une des revendications 7 ou 8, dans lequel les deuxièmes bornes externes sont formées par des bornes (111, 211, 311, 411) de modes par le branchement desquelles le mode de fonctionnement du dispositif (100... 400) d'entrée et/ou de sortie associé peut être déterminé.

10. Dispositif intégré de mémoire à semiconducteur suivant l'une des revendications 7 ou 8, dans lequel les deuxièmes bornes externes sont formées par les entrées (112, 212, 312, 412) d'adresses, et dans lequel le mode de fonctionnement des dispositifs (100... 400) d'entrée et/ou de sortie associés peut être réglé par des bits de commande appliqués aux entrées (112, 212, 312, 412) d'adresses.

11. Dispositif intégré de mémoire à semiconducteur suivant l'une des revendications 3 à 10, comportant deux dispositifs (100, 200) d'entrée et deux dispositifs (300, 400) de sortie qui peuvent être interconnectés, un dispositif (200) d'entrée pouvant fonctionner aussi en dispositif de sortie.
